# EUROPÄISCHE PATENTSCHRIFT

(11) **EP 1 196 295 B1**
(45) Veröffentlichungstag und Bekanntmachung des Hinweises auf die Patenterteilung: **02.04.2003**
(21) Anmeldenummer: 00940389.0
(22) Anmeldetag: 20.06.2000
(51) Int. Cl.: B41N 1/00, B41N 1/16, G03F 5/16

(54) **FORM EINES DRUCKELEMENTES BEIM OFFSET-DRUCKVERFAHREN**
FORM OF A PRINTING ELEMENT IN AN OFFSET PRINTING PROCESS
FORME D'UN ELEMENT D'IMPRESSION EN IMPRESSION OFFSET

(30) Priorität: 29.06.1999 DE 19929904
(43) Veröffentlichungstag der Anmeldung: 17.04.2002
(73) Patentinhaber: Sandy Screen AG, 4051 Basel (CH)
(72) Erfinder: HÄNY, Thomas, D-60385 Frankfurt am Main (DE)
(74) Vertreter: Neumann, Gerd, Dipl.-Ing.
(86) Internationale Anmeldenummer: EP0005662
(87) Internationale Veröffentlichungsnummer: WO01000420

(56) Entgegenhaltungen:
- EP-A- 0 527 655
- EP-A- 0 825 490
- DE-A- 2 917 242
- DE-A- 3 711 838
- FR-A- 1 382 265

## Beschreibung

Die Erfindung bezieht sich auf eine Form eines Druckelementes einer Vielzahl von rundum durch Stege voneinander getrennten Druckelementen an einer Druckeinheit beim Offset-Druckverfahren wie insbesondere dem rotativen Offsetdruck, wobei das jeweilige Druckelement eine geometrische, vieleckige Form aufweist.

Seit Beginn der Reprotechnik für das Offsetdruckverfahren bestand der Wunsch, anstelle der fotomechanischen Raster die alte, rasterlose Lithographie zu imitieren oder zumindest so nahe wie möglich an diese heranzukommen. Mit der Entwicklung der Fotolithographie wurde es immer deutlicher, dass mit den technisch konventionellen Rastern zwar eine relativ hohe Druckqualität erreicht werden kann, nicht aber die Nachahmung der alten Litho-Drucke. Die fotomechanischen Raster wie z. B. der Gradar- oder der Magenta-Raster eignen sich sehr gut für die neu entwickelte Fotolithographie und auch für die Reprotechnik. Diesen Rasterarten haften aber immer gewisse technischen Mängel wie Rasterabrisse, Moirébildung, Sekundär- Moirébildung und Rosetten-Bildung an. Nach wie vor besteht der Wunsch, die Originallithographie, also den Steindruck, rasterlos mit nur der Körnung der Steinoberfläche als Druckelement für den Offsetdruck zu ermöglichen.

Es besteht folglich zunächst ganz allgemein die Aufgabe, rasterlose Lithos herzustellen. Zunächst war die Idee, das Farbkorn eines Dias als Basis zu verwenden und mittels Farbauszug diese Körnung zu selektionieren und als Druckelement einzusetzen. Der Versuch scheitert an den unzulänglichen fototechnischen Materialien. Ein Teilerfolg konnte mit Computerprogrammen und PostSript-Seitenbeschreibungs Programmen erzielt werden. Da diese Rasterprogramme aber einem gesteuerten Zufallsgenerator unterliegen, besteht das Problem, dass je feiner die Auflösung der gewählten Einheiten ist, desto schwieriger die Berechnung der jeweiligen Gradationskurve ist. Wegen dieser Problematik ist diese Rasterart - wie der Cristall-, der Diamond-Screen-oder der Harlequin-HD-Screen-Raster - für die Zeitungsrotationsdruckmaschinen nicht geeignet.

Es war zu der konventionellen Rastertechnik für den Offsetdruck zurückzukehren. Beim rotativen Offsetdruck wird eine Druckplatte auf einen Zylinder gespannt. Der Zylinder arbeitet mit einem mit einem Gummituch bezogenen weiteren Zylinder zusammen und dieser wiederum mit einem Gegendruckzylinder, über den das zu bedruckende Papier geführt ist. Die druckenden Stellen der Druckplatte sind so präpariert, dass sie Wasser abstoßen und die fettige Druckfarbe annehmen. Die nicht druckenden Stellen sind wasserfreundlich präpariert und stoßen die fettige Farbe ab. Beim Drucken wird zuerst die ganze Druckplatte angefeuchtet, wobei nur die nichtdruckenden, wasserfreundlichen Stellen das Wasser annehmen. Die damit teilweise feuchte Druckplatte läuft dann an Farbwalzen vorbei, welche die fetthaltige Farbe auf die nicht feuchten Stellen der Druckplatte übertragen. Das Druckbild wird dann auf den Gummituchzylinder und von dem auf das zu bedruckende Papier übertragen.

Die zu färbenden Stellen eines Druckbildes sind in Druckelemente aufgeteilt, die mit dem bloßen Auge nicht zu erkennen sind. Jedes Druckelement ist von den benachbarten durch Stege getrennt. Die Stege werden nicht gefärbt. Je größer die Gesamtfläche der Stege in einem Bildpunkt ist, desto heller erscheint der Bildpunkt. Der Anteil der gefärbten Fläche an der Gesamtfläche eines Bildpunktes definiert einen Grauwert, den Halbtonwert des Bildpunktes, und wird normalerweise in Prozenten angegeben.

Mittels eines Rasters mit einer Vielzahl von darauf verteilten Druckelementen können durch Variieren der Druckelementgröße unterschiedliche Halbtonwerte simuliert werden. Es ist bekannt, die Druckelemente als Quadrate, als kreisrunde Flächen, als elliptische oder sonst wie geometrische Flächen zu bilden. Die Konturenschärfe der Bilder konnte bei der technisch möglichen Feinheit bei den bekannten Druckelementformen nicht voll befriedigen. Dies liegt daran, dass schon bei mittleren Druckelementgrößen, also bei mittlerem Halbtonwert des betreffenden Bildbereichs, ein Punkteschluss auftritt, so dass die Konturenschärfe sowie die Schattierungsverläufe des Druckbildes unbefriedigend sind. Bei der zu findenden Druckelementform muss der Punkteschluss soweit wie möglich nach "hinten" zur Tiefe hin gelegt, und es muss die neue Druckelementform über Gradationskurven perfekt gesteuert werden können.

Eine Lösung dieses Problems ist durch die Druckelementform nach der EP-A-0 825 490 bekannt. In jeder Zelle der schachbrettartig angeordneten imaginären Rasterzellen ist je ein Druckelement angeordnet, dass bei über die Rasterzellen gleichbleibendem beliebigem Tonwert für alle Punkte der Begrenzungslinien eines Druckelementes der jeweils kürzeste Abstand zum benachbarten Druckelement zumindest annähernd gleich groß ist. Dabei soll das Druckelement eine im wesentlichen rhomboide Fläche aufweisen, deren Begrenzungslinien derart bogenförmig verlaufen, dass sie zwei einander diagonal gegenüberliegende spitze Ecken und zwei einander diagonal gegenüberliegende runde oder stumpfe Ecken ausbilden.

Diese Druckelementform und deren Anordnung im Raster hat den Vorteil, dass rein theoretisch ein Punkteschluss erst bei einem Halbtonwert von 100 % stattfindet. Nachteilig ist allein die bei dieser Druckelementfiguration nicht zu vermeidende Moirébildung beim Vierfarbendruck. Dieses Erscheinungsbild kann man nur verhindern, wenn die Druckelemente gegenüber der normalen Anordnung um die Mittelpunktachse verdreht werden, was recht aufwendig in der regulierenden Software ist. Außerdem ist bei dieser Druckelementform nicht zu vermeiden, dass gerade, aber schräg verlaufende Linien nicht als solche abgebildet werden, sondern als leichte Zickzacklinien.

Der Erfindung liegt die Aufgabe zugrunde, eine neue Druckelementform zu entwickeln, mit der noch schärfere Reproduktionen und noch feinere, weichere Verläufe in den Schattierungen möglich sind, insbesondere aber auch die Moirébildung leicht vermeidbar ist und auch schräge gerade Linien und Kanten scharf wiedergegeben werden. Eine Teillösung dieser Aufgabe ist im Stand der Technik durch das frequenzmodulierte, durch das stochastische Raster gefunden. In der Praxis ist dieser Raster aber nicht brauchbar. Das entstehende Bild ist mit diesem Raster nur teilweise sehr gut, es kann aber genauso eine sehr schlechte Bildauflösung geliefert werden, so dass diese Art von Raster wie beschrieben letztlich verworfen wurde.

Zur Lösung der gestellten Aufgabe ist nach der Erfindung vorgesehen, dass das neue Druckelement eine geometrisch klar definierte Form aufweist und allein von geraden Linien, und zwar jeweils von mehr als sechs Schenkeln begrenzt ist. Dabei ist es von besonderem Vorteil, wenn alle Druckelemente eines definierten Bereichs eines Druckpunktes sich voneinander unterscheiden, also jedes Druckelement sich von dem benachbarten in seiner Figuration unterscheidet. Es widerspricht dem Prinzip der stets sich unterscheidenden benachbarten Druckelemente nicht, wenn dieser definierte Bereich, der beispielsweise 15 Druckelemente unterschiedlicher Figuration umfasst, sich in der Art eines Rapports über die Größe eines Druckpunktes wiederholt. Voraussetzung ist nur, dass auch hier das jeweils benachbarte Druckelement sich vom vorhergehenden unterscheidet. Dies ist beispielsweise leicht durchführbar, wenn die Rapportfläche frühestens nach einem zweiten sich unterscheidenden Druckelement folgt.

Die Druckelemente sollen von mehr als sechs Schenkeln, vorzugsweise von 9 - 11 Schenkeln begrenzt sein. Dabei sind diese auch von unterschiedlicher Länge und folgen einander in Ecken, die einen spitzen oder auch stumpfen Winkel einschließen können. Es ist sogar möglich, dass ein Schenkel eines benachbarten Druckelementes an irgend einer Stelle über die Länge des unmittelbar benachbarten Schenkels beginnt. Auch dadurch ist die ungleichmäßige Figuration und Verteilung der Druckelemente über die Fläche eines Druckpunktes gewährleistet. Es sollten aber die einzelnen Druckelemente alle eine Druckfläche aufweisen, die sich in der Flächengröße im wesentlichen nicht voneinander unterscheidet.

Diese Art der jeweils zu den Nachbarelementen unterschiedlichen, aber geometrisch klar definierbaren Druckelemente kommt dem Begriff "Druckelement" oder dem rasterlosen Druckbild am nächsten. Es ist in jeder berechenbaren Feinheit einsetzbar und eignet sich damit für alle Offsetdruckverfahren vom hochqualifizierten Zeitungs- bis zum hochqualifizierten Bodendruck. Diese Art der in der Nachbarschaft unterschiedlichen Druckelementformen bietet erstmals die Möglichkeit, lithographieähnlich zu drucken.

Damit das Druckbild unterschiedliche Helligkeitsstufen, einen sich ändernden Tonwert aufweisen können, müssen die Druckelemente von dem benachbarten durch eine Fläche getrennt sein, die nicht angefärbt ist. Diese (weiße) Flächen sind bei der Anordnung nach dieser Idee stets stegförmig, und zwar derart, dass die nebeneinander angeordneten Druckelemente des Rasters - ohne eine schachbrettartige Anordnung - einander so zugeordnet sind, dass bei jedem und auch bei sich änderndem Tonwert die Abstände der beiden oder über die Länge eines Schenkels mehreren benachbarten geraden Schenkeln zum nächsten Druckelement über die Länge des geraden Schenkels konstant ist. Diese Anordnung ist die Voraussetzung für einen Punkteschluss der jeweils benachbarten Druckelemente erst bei einem Halbtonwert von etwa 100 %. Die Folge dieser Anordnung sind weiche Helligkeitsunterschiede, sind optimale Konturenschärfen bei Bildern.

Dieses Druckelement, diese jeweils sich von dem benachbarten Druckelement unterscheidenden Druckelemente sind nicht nur für die schwarzweiß Reproduktion im Zeitungs-, Rollen- oder Bogenoffsetdruck von Vorteil, sondern auch für den Vierfarbendruck. Jedes Druckelement dieser verschiedenartigen Figuration oder auch nur eine bestimmte Gruppe von Druckelementen kann in eine der vier Farben gefärbt sein. Es entsteht dabei weder eine Moirebildung noch sind Zick-Zack-Linien, gleichgültig in welcher Neigung und Länge auch immer, zu erkennen.

Die verschiedenartigen Formen in einem erfindungsgemäßen Druckelementpunkt sind in der Zeichnung beispielhaft dargestellt. Es zeigen:
Fig. 1 In schematischer Darstellung einen Schnitt durch die Walzen eines bekannten Offsetdruckwerks,
Fig. 2 in starker Vergrößerung in der Draufsicht ein einzelnes ganzes Druckelement mit mehreren dieses umgebenden anderen Druckelementen jeweils unterschiedlicher Figuration,
Fig. 3 in etwas Verkleinerung eine Anzahl Druckpunkten in der Rapportfläche nach Fig. 2 mit gleichem Tonwert,
Fig. 4 ebenfalls in starker, jedoch kleinerer Vergrößerung eine Anzahl von unterschiedlich großen Druckelementen, also mit sich veränderndem Abstand und somit mit sich veränderndem Tonwert,
Fig. 5 ein Druckpunkt ähnlich dem nach Fig. 2 mit einer größeren Anzahl von unterschiedlichen und insbesondere vollständigen Druckelementen innerhalb des Druckpunktes, wobei 5b ein vollständiges und 5a nur ein Teil eines solchen Druckelementes darstellt,
Fig. 6 in Verkleinerung eine Vielzahl Druckpunkten in der Rapportfläche nach Fig. 5 alle mit gleichem Tonwert und
Fig. 7 ein Druckpunkt nach dem Prinzip der Erfindung, jedoch ohne ein einziges vollständiges Druckelement innerhalb des imaginären Vierecks.

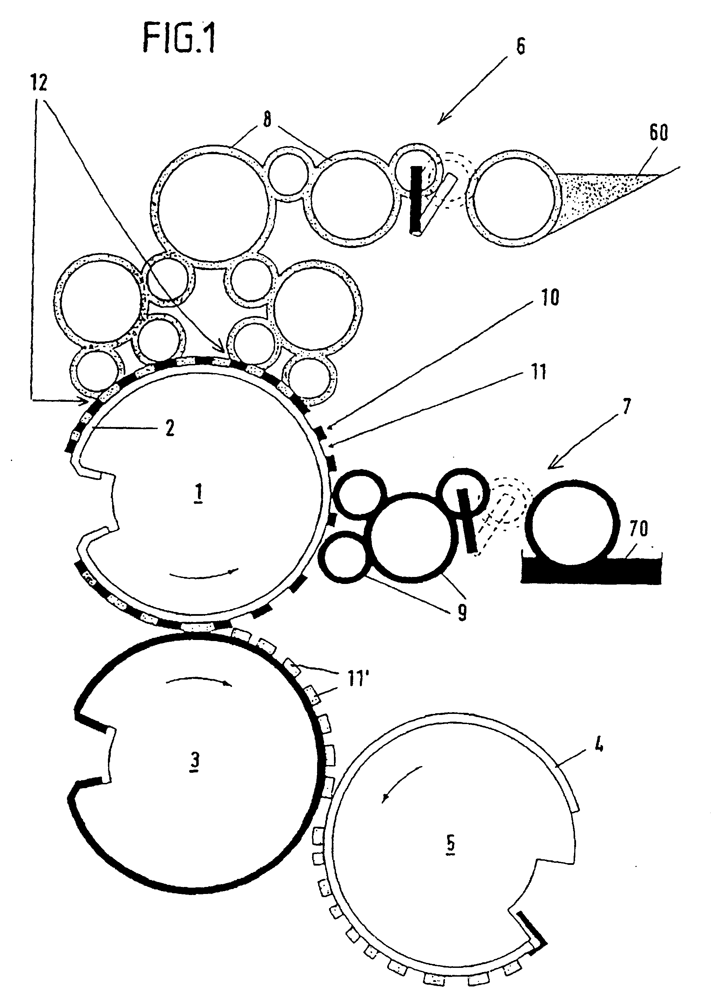

Das Offsetdruckwerk nach Fig. 1 arbeitet mit einem Plattenzylinder 1, auf den eine Druckplatte 2 aufgespannt ist. Der Plattenzylinder 1 arbeitet einerseits mit einem Gummituchzylinder 3 und dieser weiterhin mit einem mit dem zu bedruckenden Druckträger, wie Papier 4, bespannten Gegendruckzylinder 5 und andererseits mit dem Farbwerk 6 und dem Feuchtwerk 7 zusammen. Die Übertragung der Druckfarbe 60 auf die Druckplatte 2 durch das Farbwerk 6 erfolgt über eine Anzahl von Druckrollen 8. Die Übertragung des Wassers 70 durch das Feuchtwerk 7 erfolgt über eine Anzahl weiterer Übertragungswalzen 9. Alle Walzen bzw. Zylinder arbeiten gegenläufig zueinander, wie teilweise durch die Pfeile angegeben.

Durch das Feuchtwerk 7 wird Wasser 70 an nichtdruckende Stellen 10 der Druckplatte 2 übertragen, während die druckenden Stellen 11 der Druckplatte 2 von Wasser befreit bleiben. Die feuchten Stellen 10 stoßen die Druckfarbe 60 an den Auflagestellen 12 der aufliegenden Druckwalzen 8 ab, während druckenden Stellen 11 die Druckfarbe annehmen. Die Druckfarbe wird dann von der Druckplatte 2 auf den Gummituchzylinder 3 übertragen und bildet dort Farbstellen 11', die schließlich auf den Druckträger 4 gedruckt werden.

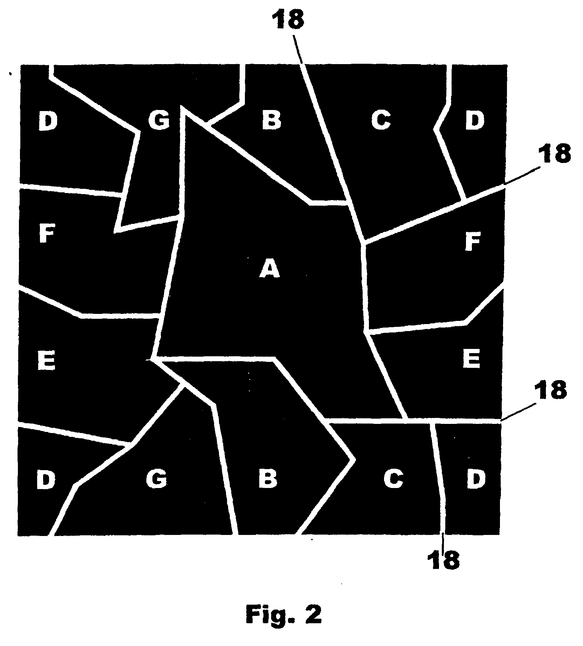

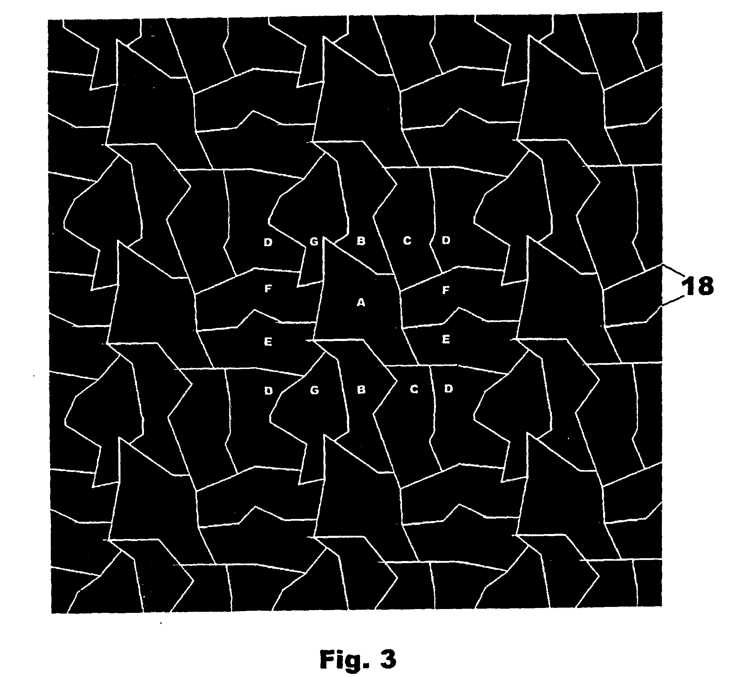

Die druckenden Stellen 11 bzw. die Farbstellen 11' sind Druckelemente gemäß Fig. 2 und 3. Diese sind sehr klein und mit dem bloßen Auge nicht voneinander zu trennen. Die Fig. 2 zeigt in starker Vergrößerung in der Mitte eines in einer Rapportfläche definierten Druckpunktes oder eines imaginären Vierecks ein solches Druckelement in der erfindungsgemäßen Vielschenkel-Figurierung. Jedes Druckelement, ob nun das in der Fläche vollständig in Fig. 2 dargestellte Druckelement A oder die peripheren Druckelemente B bis G haben etwa die gleiche Größe in der Druckfläche, aber unterscheiden sich in der Figuration jeweils grundsätzlich. Dies geht aus Fig. 2, insbesondere aber aus Fig. 3 hervor, weil dort alle Druckelementtypen in der vollflächigen Figuration abgebildet sind.

Wenn auch die Druckelemente A - G jeweils unterschiedlich lange gerade Schenkellinien zeigen, sie sind jeweils von neun bis elf Schenkeln begrenzt, so haben sie auch jeweils mehrere Ecken mit jeweils unterschiedlichen eingeschlossenen Winkeln von 40 bis 320°. Die Druckelemente sind nicht nur in ihrer Grundfläche stets gleich, sondern die einzelnen sich unterscheidenden Druckelemente sind unmittelbar derart nebeneinander angeordnet, dass die Abstände der jeweiligen Schenkel von den entsprechenden Schenkeln der jeweils benachbarten Druckelemente immer konstant sind. Die nicht druckenden Stege 18 sind stets gleich breit. Dies ist die Voraussetzung für die Vermeidung eines Punkteschlusses bereits bei Tonwerten, die unter 100 % liegen. Bei den Druckelementen A - G, die völlig unabhängig von einer schachbrettartigen Anordnung über die Fläche eines Druckpunktes verteilt sind, ergibt sich nie ein Punkteschluss, es sei denn, der spezielle Druckpunkt soll exakt schwarz sein.

Wenn auch jedes Druckelement A bis G sich voneinander unterscheidet und die sie trennenden Stege 18 bei gleichem Tonwert alle und immer gleich breit sind, so wiederholen sich diese Druckelemente A bis G doch über die Fläche eines größeren Druckpunktes in Abhängigkeit eines Rapports, dessen Fläche aus Fig. 2 hervorgeht.

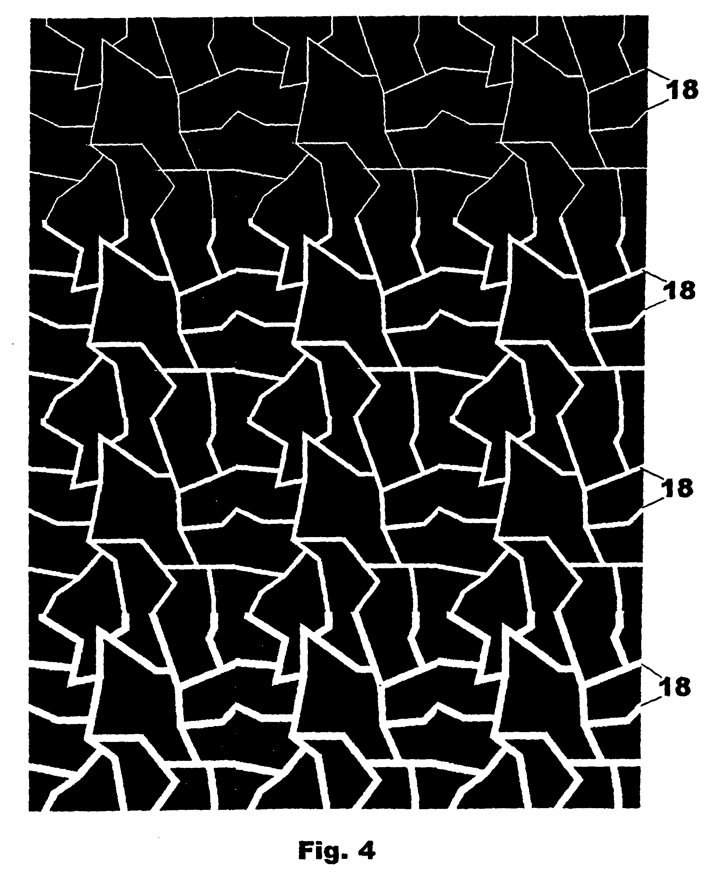

Zur Ergänzung ist noch auf die Fig. 4 zu verweisen, wo unverändert die jeweils unterschiedlichen Druckelemente A - G gezeichnet sind, jedoch über die Fläche der Figur 4 oder des Druckpunktes die jeweiligen Abstände zwischen den Druckelementen, also die Stege 18 sich in der Breite verändern. Damit ändert sich auch der Tonwert. Das Abgebildete wird zur unteren Kante des Bildes heller. Die Verbreiterung der Stege kann - wie oben zu sehen - kontinuierlich oder in größeren Prozentsprüngen - wie unten zu sehen - erfolgen. Der Prozentsprung im unteren Teil des Bildes ist nur größer, so dass er in dieser Auflösung stärker sichtbar ist.

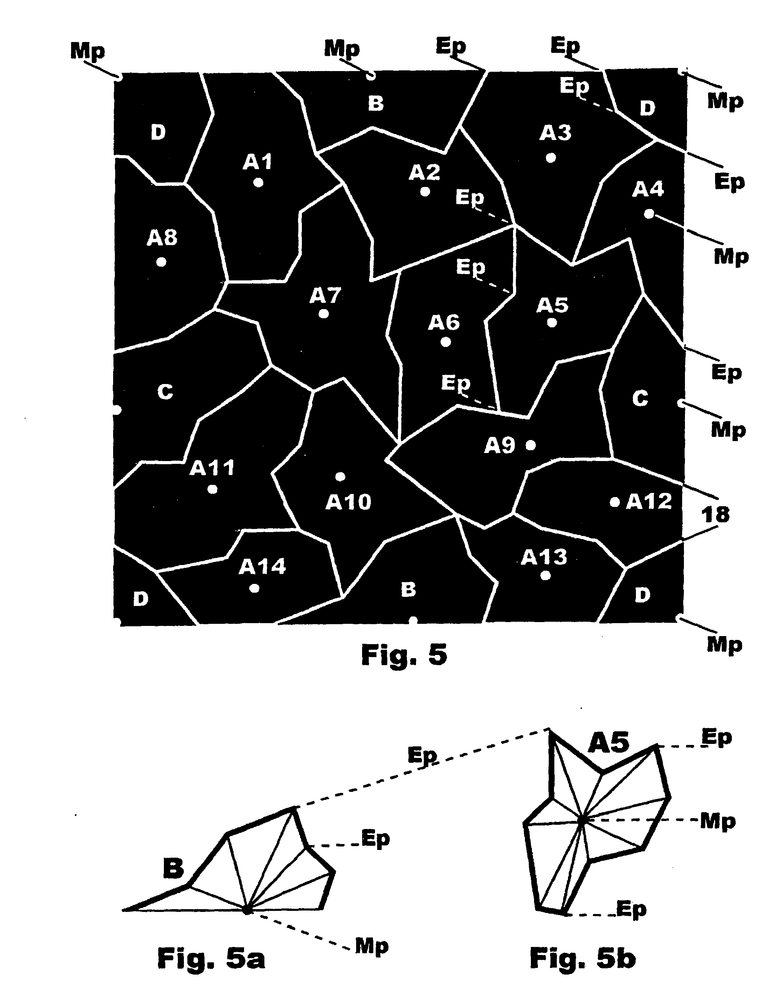

Die Fig. 5 offenbart eine bessere Auflösung innerhalb eines Druckpunktes mit einer Vielzahl von unterschiedlich figurierten, vollständigen Druckelementen A1 - A14 innerhalb dieses imaginären Viereckes. Jedes Druckelement A1 - A14 hat innerhalb seiner Fläche einen mit einem weißen Punkt dargestellten Mittelpunkt Mp, von dem aus Linien zu den Ecken Ep ziehbar sind, wie es in den Fig. 5a und 5 b offenbart ist. Die dabei jeweils entstehenden Dreiecke überschneiden, überdecken sich nicht, sondern sind stets klar als Dreiecke figuriert. Von diesem Mittelpunkt Mp aus, der innerhalb eines Druckpunktes gemäß Fig. 5 durch seine Koordinaten festgelegt ist, wird die Größe der färbenden Fläche des Druckelementes bzw. wird die Breite der Stege 18 bestimmt. Ein jedes Druckelement A1 - A14 wird also mathematisch von seinem Mittelpunkt Mp aus aufgebaut.

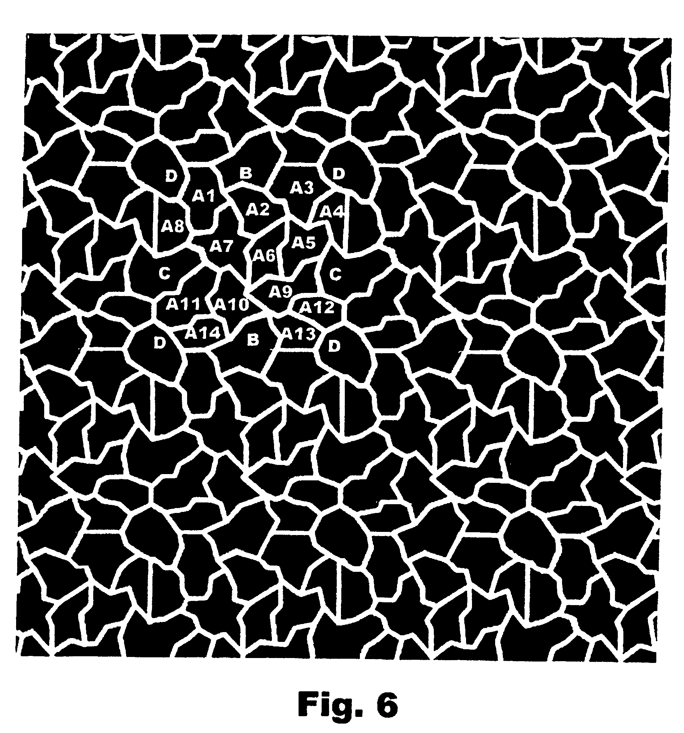

Neben den vollständigen Druckelementen gemäß Fig. 5b ist ein Druckpunkt noch durch Teil-Druckelemente B, C, D, wie das Element B gemäß Fig. 5a, begrenzt, dessen Mittelpunkt Mp auf einer Linie des imaginären Vierecks liegt. Ein solches Teil-Druckelement ergänzt sich gemäß Fig. 6 zu einem ganzen Druckelement B, mit dem mit dem gleichen Buchstaben bezeichneten Schwesterelement an der Kante des benachbarten Druckpunktes.

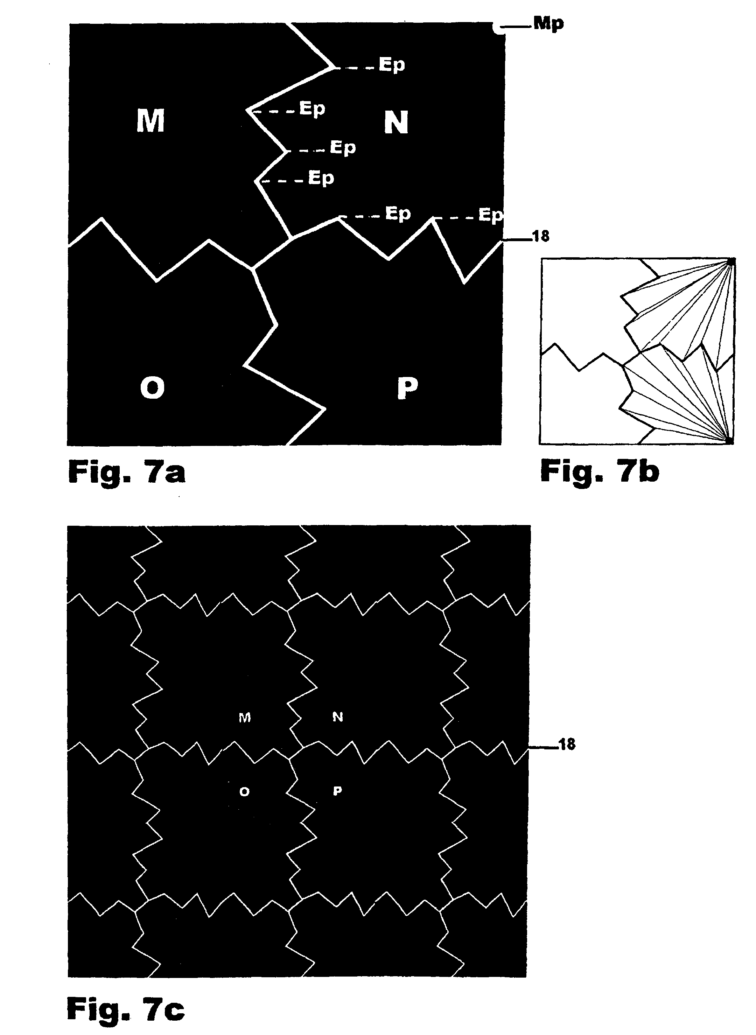

Die Figuren 7a bis 7c offenbaren wiederum ein anderes Druckelement mit anderer Figuration, bei dem aber die Grundidee der Erfindung nicht verlassen ist. Gemäß Fig. 7a besteht ein Druckpunkt aus vier Teil-Druckelementen M, N, O, und P, deren Mittelpunkt Mp nicht nur auf einer Linie des imaginären Vierecks, sondern in dessen Ecken liegt. Es ist dazu auf die Fig. 7b zu verweisen. Die polygonale Figuration eines Druckelementes mit der Vielzahl von Eckpunkten Ep geht insbesondere aus der Fig. 7c hervor, in der die Teil-Druckelemente M, N, O, und P um 90° gedreht dargestellt sind. Die weißen Linien stellen, wie bei allen anderen Figurationen, die Stege 18 dar, die je nach dem gewünschten Tonwert breiter sind. Die prinzipielle Figuration des Druckelements mit seiner Vielzahl von Schenkeln 18 bleibt unverändert.

## Patentansprüche

1. Druckelement zur Simulation von Tonwerten auf einem Druckträger mit einer Vielzahl von über die Fläche des Rasters verteilten Druckelementen, **dadurch gekennzeichnet, dass** das jeweilige Druckelement (A - G; A1 - A14; M - P) eine geometrisch klar definierte Form aufweist und allein von geraden Linien, und zwar jeweils von mehr als sechs Schenkeln begrenzt ist.

2. Druckelement nach Anspruch 1, **dadurch gekennzeichnet, dass** das Druckelement (A - G; A1 - A14; M - P) von 9 bis 11 Schenkeln begrenzt ist.

3. Druckelement nach Anspruch 1 oder 2, **dadurch gekennzeichnet, dass** das Druckelement (A - G; A1 - A14; M - P) von Schenkeln ungleichmäßiger Länge begrenzt ist.

4. Druckelement nach einem der vorhergehenden Ansprüche, **dadurch gekennzeichnet, dass** dieses ein Polygon (A - G; A1 - A14; M - P) ist aus beliebig unterschiedlich langen Schenkeln, die mit beliebig unterschiedlich großen Winkeln aneinander stoßen.

5. Druckelement nach Anspruch 4, **dadurch gekennzeichnet, dass** die Winkel zwischen den Schenkeln an den Eckpunkten (Ep) des Polygons zwischen 5° und 175° liegen, jedenfalls nicht größer als 180° sind.

6. Druckelement nach Anspruch 4 oder 5, **dadurch gekennzeichnet, dass** aneinander grenzende Schenkel eines Druckelementes (A - G; A1 - A14; M - P) einmal einen spitzen und nachfolgend einen stumpfen Winkel einschließen.

7. Druckelement nach einem der vorhergehenden Ansprüche, **dadurch gekennzeichnet, dass** jedes Druckelement (A - G; A1 - A14; M - P) sich von dem benachbarten in seiner Figuration unterscheidet.

8. Druckelement nach einem der vorhergehenden Ansprüche, **dadurch gekennzeichnet, dass** innerhalb eines imaginären Vierecks, das einen Druckpunkt darstellt, nur ein Teil'(A - D; M - P) eines von mehreren Schenkeln begrenzten Druckelements angeordnet ist.

9. Druckelement nach Anspruch 8, **dadurch gekennzeichnet, dass** das imaginäre Viereck nur von Teilen (M - P) eines Druckelementes ausgefüllt ist.

10. Druckelement nach einem der vorhergehenden Ansprüche, **dadurch gekennzeichnet, dass** innerhalb des imaginären Vierecks ein vollständig mit Schenkeln rundum begrenztes Druckelement (A) angeordnet ist.

11. Druckelement nach Anspruch 10, **dadurch gekennzeichnet, dass** innerhalb des imaginären Vierecks mehr als ein vorzugsweise sechs vollständig mit Schenkeln rundum begrenzte Druckelemente (A1 - A14) angeordnet sind.

12. Druckelement nach einem der vorhergehenden Ansprüche, **dadurch gekennzeichnet, dass** die Figuration der sich stets unterscheidenden Druckelemente (A - G; A1 - A14; M - P) sich nach einer Rapportfläche (Fig. 2, 6), die dem imaginären Viereck entspricht, wiederholt.

13. Druckelement nach einem der Ansprüche 10 bis 12, **dadurch gekennzeichnet, dass** ein benachbartes Druckelement (A4, A8) dieses vollständigen Druckelements zumindest eine Begrenzungskante parallel zu dem imaginären Viereck aufweist.

14. Druckelement nach einem der vorhergehenden Ansprüche, **dadurch gekennzeichnet, dass** ein Schenkel eines benachbarten Druckelementes (A, C) im Bereich der Länge des Schenkels eines benachbarten Druckelementes (B) beginnt.

15. Druckelement nach einem der vorhergehenden Ansprüche, **dadurch gekennzeichnet, dass** alle Druckelemente (A - G; A1 - A14; M - P) trotz ihrer jeweils völlig voneinander sich unterscheidenden Figuration in Ihrer Druckfläche im wesentlichen gleich groß sind.

16. Druckelement nach einem der vorhergehenden Ansprüche, **dadurch gekennzeichnet, dass** in jedem Druckelement ein Mittelpunkt (Mp) definiert ist, dessen Anordnung innerhalb des imaginären Vierecks sich bei sich änderndem Tonwert nicht ändert.

17. Druckelement nach Anspruch 16, **dadurch gekennzeichnet, dass** die imaginären Linien vom Mittelpunkt (Mp) zu den Ecken (Ep) des Polygons klar begrenzte Dreiecke umschließen, sich also die Dreiecke nicht gegeneinander überdecken.

18. Druckelement nach Anspruch 17, **dadurch gekennzeichnet, dass** der Mittelpunkt (Mp) eines Druckelementes auf der imaginären Linie des Rechtecks (Fig. 5a, 7b) liegt.

19. Druckelement nach einem der vorhergehenden Ansprüche, **dadurch gekennzeichnet, dass** die nebeneinander angeordneten Druckelemente (A - G; A1 - A14; M - P) des Rasters - ohne eine schachbrettartige Anordnung - einander derart zugeordnet sind, dass vorzugsweise bei jedem und auch bei sich änderndem Tonwert die Abstände der beiden benachbarten geraden Schenkel (18) zum nächsten Druckelement über die Länge der geraden Schenkel (18) konstant sind.

20. Druckelement nach Anspruch 19, **dadurch gekennzeichnet, dass** sich die Größe des Polygons von seinem Mittelpunkt (Mp) gleichmäßig zu den Eckpunkten (Ep) in Abhängigkeit des angestrebten Tonwertes verändert und dabei rundum die gleichmäßig breiten Abstände zum jeweils benachbarten Schenkel (18) des benachbarten Druckelements gleichmäßig zu- oder abnehmen.

21. Druckelement nach einem der vorhergehenden Ansprüche, **dadurch gekennzeichnet, dass** die benachbarten, jeweils unterschiedlich in der Figuration hergestellten Druckelemente (A - G; A1 - A14; M - P) in jeder beliebigen Farbe anfärbbar sind.

## Claims

1. Printing element for simulating tonal values on a printing substrate, having a plurality of printing elements distributed over the area of the screen, **characterised in that** the individual printing element (A - G; A1 - A14; M - P) has a geometrically clearly defined form and is bounded by straight lines alone, namely by more than six sides in each case.

2. Printing element according to claim 1, **characterised in that** the printing element (A - G; A1 - A14; M - P) is bounded by 9 to 11 sides.

3. Printing element according to claim 1 or 2, **characterised in that** the printing element (A - G; A1 - A14; M - P) is bounded by sides of unequal length.

4. Printing element according to one of the foregoing claims, **characterised in that** it is a polygon (A - G; A1 - A14; M - P) with sides of any desired different lengths which meet one another at angles of any desired different sizes.

5. Printing element according to claim 4, **characterised in that** the angles between the sides at the corners (Ep) of the polygon are between 5° and 175° or at least are not more than 180°.

6. Printing element according to claim 4 or 5, **characterised in that** sides of a printing element (A - G; A1 - A14; M - P) that meet include first an acute angle and then an obtuse angle.

7. Printing element according to one of the foregoing claims, **characterised in that** each printing element (A - G; A1 - A14; M - P) differs from the adjoining one in respect of its figuration.

8. Printing element according to one of the foregoing claims, **characterised in that** only a part (A - D; M - P) of a printing element bounded by a plurality of sides is arranged within an imaginary quadrilateral which represents a printing dot.

9. Printing element according to claim 8, **characterised in that** the imaginary quadrilateral is filled by only parts (M - P) of a printing element.

10. Printing element according to one of the foregoing claims, **characterised in that** a printing element (A) bounded completely by sides all round is arranged within the imaginary quadrilateral.

11. Printing element according to claim 10, **characterised in that** more than one and preferably six printing elements (A1 - A14) bounded completely by sides all round are arranged within the imaginary quadrilateral.

12. Printing element according to one of the foregoing claims, **characterised in that** the figuration of the always differing printing elements (A - G; A1 - A14; M - P) is repeated as a repeat area (Figs.2, 6) which corresponds to the imaginary quadrilateral.

13. Printing element according to one of claims 10 to 12, **characterised in that** a printing element (A4, A8) adjoining said complete printing element has at least one boundary edge parallel to the imaginary quadrilateral.

14. Printing element according to one of the foregoing claims, **characterised in that** one side of an adjoining printing element (A, C) starts along the length of the side of an adjoining printing element (B).

15. Printing element according to one of the foregoing claims, **characterised in that** the printing areas of all the printing elements (A - G, A1- A14; M - P) are substantially the same despite the fact that their figurations are in each case entirely different from one another.

16. Printing element according to one of the foregoing claims, **characterised in that** defined in each printing element there is a centre (Mp) whose position within the imaginary quadrilateral does not change when the tonal value changes.

17. Printing element according to claim 16, **characterised in that** the imaginary lines from the centre (Mp) to the corners (Ep) of the polygon enclose clearly bounded triangles, and the triangles are therefore not congruent.

18. Printing element according to claim 17, **characterised in that** the centre (Mp) of a printing element is situated on the imaginary line of the quadrilateral (Figs.5a, 7b).

19. Printing element according to one of the foregoing claims, **characterised in that** the printing elements (A - G; A1 - A14; M - P) which are arranged next to one another in the screen - without being arranged in a chessboard pattern - are so associated with one another that, preferably at any tonal value and even when the tonal value changes, the distances between two adjoining straight sides (18) and the next printing element is constant along the length of the straight sides (18).

20. Printing element according to claim 19, **characterised in that** the size of the polygon from its centre (Mp) to the corners (Ep) changes regularly as a function of the tonal value being aimed at and at the same time the distances of uniform width to whichever is the adjoining side (18) of the adjoining printing element increase or decrease equally all round.

21. Printing element according to one of the foregoing claims, **characterised in that** the adjoining printing elements (A - G; A1 - A14; M - P) which are each created in a different figuration can be inked in any desired colour.

## Revendications

1. Elément d'impression destiné à simuler des valeurs de nuance sur une forme imprimante dotée d'une multitude d'éléments d'impression répartis sur toute la surface de la trame, et caractérisé en que l'élément d'impression (A - G ; A1 - A14 ; M - P) présente une forme géométriquement bien définie et est délimité exclusivement par des lignes droites, et par plus de six montants.

2. Elément d'impression selon la revendication 1, **caractérisé en ce que** l'élément d'impression (A - G ; A1 - A14 ; M - P) est délimité par 9 à 11 montants.

3. Elément d'impression selon la revendication 1 ou 2, **caractérisé en ce que** l'élément d'impression (A - G ; A1 - A14, M - P) est délimité par des montants de différentes longueurs.

4. Elément d'impression selon une des revendications précédentes, **caractérisé en ce que** cet élément est composé de montants de longueur arbitraire, qui butent les uns contre les autres suivant des angles d'amplitude arbitraire.

5. Elément d'impression selon la revendication 4, **caractérisé en ce que** les angles entre les montants présentent, aux points de croisement (Ep) du polygone, une amplitude située entre 5 et 175°, mais ne dépassant en tous cas pas les 180°.

6. Elément d'impression selon la revendication 4 ou 5, **caractérisé en ce que** des montants contigus d'un élément de pression (A - G ; A1 - A14 ; M - P) comprennent un angle aigu puis un angle obtus.

7. Elément d'impression selon une des revendications précédentes, **caractérisé en ce que** chaque élément d'impression (A - G ; A1 - A14 ; M - P) se distingue de l'élément voisin par sa représentation.

8. Elément d'impression selon une des revendications précédentes, **caractérisé en ce que** seule une partie (A - D ; M - P) d'un élément d'impression délimité par plusieurs montants est disposée à l'intérieur d'un carré imaginaire représentant un point d'impression.

9. Elément d'impression selon la revendication 8, **caractérisé en ce que** le carré imaginaire n'est rempli que par des parties (M - P) d'un élément de pression.

10. Elément d'impression selon une des revendications précédentes, **caractérisé en ce que** un élément d'impression (A) délimité entièrement par des montants est disposé à l'intérieur du carré imaginaire.

11. Elément d'impression selon la revendication 10, **caractérisé en ce que** de préférence plus de six éléments d'impression (A1 - A14) délimités entièrement par des montants sont disposés à l'intérieur du carré imaginaire.

12. Elément d'impression selon une des revendications précédentes, **caractérisé en ce que** la représentation des six éléments d'impression toujours distinctifs (A - G ; A1 - A14 ; M - P) se répète derrière une surface de rapport (Fig. 2, 6) correspondant au carré imaginaire.

13. Elément d'impression selon une des revendications 10 à 12, **caractérisé en ce que** un élément d'impression voisin (A4, A8) de cet élément d'impression complet présente, parallèlement au carré imaginaire, au moins une arête de délimitation.

14. Elément d'impression selon une des revendications précédentes, **caractérisé en ce que** un montant d'un élément d'impression voisin (A, C) commence dans la zone de la longueur du montant d'un élément d'impression voisin (B).

15. Elément d'impression selon une des revendications précédentes, **caractérisé en ce que** tous les éléments d'impression (A - G ; A1 - A14 ; M - P), malgré leur représentation entièrement distincte les unes des autres, présentent une surface d'impression essentiellement de même taille.

16. Elément d'impression selon une des revendications précédentes, **caractérisé en ce que** un point central (Mp) dont la disposition à l'intérieur du carré imaginaire ne varie pas en cas de modification de la valeur de nuance a été défini dans chaque élément d'impression.

17. Elément d'impression selon la revendication 16, **caractérisé en ce que** les lignes imaginaires menant du point central (Mp) aux angles (Ep) du polygone incluent des triangles clairement délimités, ces triangles ne se chevauchant donc pas.

18. Elément d'impression selon la revendication 17, **caractérisé en ce que** le point central (Mp) d'un élément d'impression repose sur la ligne imaginaire du quadrilatère rectangle (Fig. 5a, 7b).

19. Elément d'impression selon une des revendications précédentes, **caractérisé en ce que** les éléments d'impression (A - G ; A1 - A14 ; M - P) juxtaposés de la trame - sont reliés les uns par rapport aux autres - sans disposition en damier - de telle sorte que les distances entre les deux montants droits voisins (18) et l'élément d'impression le plus proche via la longueur du montant droit (18) soient constantes, si possible pour chaque valeur de nuance, ainsi que pour chaque modification de cette valeur.

20. Elément d'impression selon la revendication 19, **caractérisé en ce que** la taille du polygone varie uniformément de son point central (Mp) jusqu'aux points angulaires (Ep), en fonction de la valeur de nuance recherchée, et **en ce que** les écartements uniformes par rapport au montant (18) voisin de l'élément d'impression voisin augmentent ou diminuent uniformément.

21. Elément d'impression selon une des revendications précédentes, **caractérisé en ce que** les éléments d'impression voisins de représentation différente (A - G ; A1 - A14 ; M - P) peuvent être teintés dans la couleur de son choix.
